# FASCICULE DE BREVET EUROPEEN

(11) **EP 3 103 137 B1**
(45) Date de publication et mention de la délivrance du brevet: **21.07.2021**
(21) Numéro de dépôt: 15713195.4
(22) Date de dépôt: 04.02.2015
(51) Int. Cl.: H01L 21/683, H01J 37/32

(54) **PORTE-SUBSTRAT ÉLECTROSTATIQUE CHAUFFANT ET POLARISÉ EN HAUTE TENSION**
ELEKTROSTATISCH ERHITZENDER SUBSTRATHALTER MIT POLARISIERUNG BEI HOHER SPANNUNG
ELECTROSTATIC HEATING SUBSTRATE HOLDER WHICH IS POLARISED AT HIGH VOLTAGE

(30) Priorité: 07.02.2014 FR 1400352
(43) Date de publication de la demande: 14.12.2016
(73) Titulaire: Ion Beam Services, 13790 Peynier (FR)
(72) Inventeur: TORREGROSA, Frank, F-13109 Simiane (FR); ROUX, Laurent, F-13013 Marseille (FR)
(74) Mandataire: Cabinet Prugneau-Schaub
(86) Numéro de dépôt international: PCT/FR2015/000028
(87) Numéro de publication internationale: WO 2015/118237

(56) Documents cités:
- FR-A1- 2 985 087
- US-A1- 2013 286 533

## Description

La présente invention concerne un porte-substrat électrostatique chauffant et polarisé en haute tension.

Le domaine de l'invention est celui du traitement de substrats dans une atmosphère sous faible pression lorsque ces substrats sont polarisés en haute tension.

Plus particulièrement, on vise l'implantation ionique qui permet l'introduction d'impuretés à l'intérieur du substrat, technique connue sous le nom de dopage. Le dopage permet de modifier certaines des propriétés du substrat qu'elles soient mécaniques, thermiques, électriques, hydrophobiques ou autres.

Pour réaliser cette implantation, on peut maintenant utiliser un implanteur ionique opérant en mode immersion plasma. Ainsi, l'implantation ionique d'un substrat consiste à l'immerger dans un plasma et à le polariser en tension négative, de quelques dizaines de Volts à quelques dizaines de kilovolts (généralement moins de 100 kV), ceci de façon à créer un champ électrique capable d'accélérer les ions du plasma vers le substrat de sorte qu'ils s'y implantent. Les atomes ainsi implantés sont dénommés dopants. La polarisation est généralement puisée.

Dans certaines applications, il convient de chauffer le substrat.

On connaît ainsi des machines d'implantation qui utilisent des lampes infrarouges pour chauffer le substrat. Cette situation convient bien pour implanter des pièces mécaniques au moyen d'un plasma qualifié de propre (azote, oxygène, ...). Elle ne convient pas lorsqu'il s'agit de doper du silicium : le plasma utilisé est susceptible de créer des dépôts parasites sur les lampes, ce qui masque le rayonnement et perturbe le chauffage.

On connaît ainsi des machines d'implantation employant des enceintes à murs chauds. On peut à ce sujet se référer à l'ouvrage « Handbook of Plasma Immersion Ion Implantation and Déposition », année 2000, édité par André ANDERS, publié par John WILEY & Sons, ISBN 0-471-24698-0. L'échange thermique entre les murs chauds et le substrat est médiocre lorsque la pression du travail est très basse car il n'y a pratiquement pas de convection. L'échange thermique par rayonnement si l'on souhaite porter le substrat à haute température (supérieure à 300°C) est inefficace car les pertes sont considérables. Il faut surdimensionner la puissance du chauffage et cela pose des problèmes d'étanchéité : tenue des joints, déformation des composants mécaniques, ....

On connaît encore des machines d'implantation qui polarisent le substrat alternativement en tension négative et en tension positive. L'alternance négative attire les ions et elle est donc utilisée pour l'implantation. L'alternance positive attire les électrons qui vont transférer leur énergie au substrat en le chauffant. La température est contrôlée en jouant sur le rapport cyclique et/ou en jouant sur la tension d'accélération des électrons. Cette solution convient bien pour le traitement de surface de pièces qui ne sont pas sensibles. En microélectronique, plus particulièrement sur le silicium, les électrons énergétiques sont susceptibles de créer des défauts induisant une réduction de la durée de vie des porteurs.

Le document US 7,094,670 montre l'intérêt de contrôler la température du substrat pour maîtriser la gravure ou le dépôt parasite lorsqu'on utilise un plasma réactif. Il en ressort que la température doit être supérieure au seuil nécessaire pour le dépôt de matériaux formés à partir du gaz employé (par exemple, polymères du type hydrure de bore). D'autre part, la température doit être inférieure au seuil nécessaire à la gravure du substrat en silicium, qu'il soit polycristallin, monocristallin ou amorphe. Ici, la température du porte-substrat est contrôlée au moyen de la circulation d'un fluide caloporteur à température stable. La température du substrat dépend du flux énergétique provenant du plasma et de la résistance thermique entre le substrat et le porte-substrat. Il s'ensuit que la température obtenue est fortement dépendante du procédé mis en œuvre. Si le fluide caloporteur est chauffé, sa température ne dépasse pas pratiquement 200°C. Ainsi, on ne peut atteindre une température élevée si l'on emploie un plasma de faible densité, et/ou une faible tension d'accélération et/ou un faible courant d'implantation.

Il découle de ce qui précède que le chauffage du substrat dans le cadre de l'implantation ionique par immersion plasma est un réel problème. Ce problème est d'autant plus délicat si l'on emploie un porte-substrat électrostatique.

Les avantages d'un tel porte-substrat sont bien connus de l'homme du métier et il n'est donc pas nécessaire de les rapporter ici.

A ce propos, le document US 6,538,872 enseigne un porte-substrat électrostatique pourvu d'un moyen de chauffage résistif. Ce système permet de chauffer le substrat indépendamment des paramètres du plasma. Toutefois, ce porte-substrat ne peut être polarisé en haute tension du fait de sa constitution. Il n'est pas prévu d'isolation des différents modules constituant ce porte-substrat. De plus, le module qui comporte la résistance de chauffage est inséré dans une pièce en contact avec le porte-substrat proprement dit. La liaison du module de chauffage au porte-substrat est faite par brasure afin d'optimiser le transport thermique. Cette brasure contient des métaux tel que l'étain, l'indium ou le cuivre et ces métaux sont des contaminants majeurs dans le cas de l'implantation ionique.

Le document FR 2985 087 divulgue un porte-substrat électrostatique de traitement d'un substrat semiconducteur, muni d'un élément électriquement conducteur pour raccorder un plan d'appui du substrat à un épaulement du porte-substrat, mais ne permettant pas le chauffage du substrat.

La présente invention a ainsi pour objet de proposer un moyen de chauffage dépourvu des limitations énoncées ci-dessus, ceci lorsque le porte-substrat est polarisé en haute tension.

Un support selon l'invention correspond au support selon la revendication 1.

Un tel agencement répond au problème posé puisqu'il permet de chauffer le substrat à haute température et de la polariser en haute tension.

Suivant une caractéristique additionnelle, le porte-substrat étant pourvu d'un épaulement à sa base, il comporte de plus une bride de serrage électriquement conductrice pour brider l'épaulement sur la table polarisée.

Dans ce cas, le support comporte au moins un élément électriquement conducteur pour raccorder le plan d'appui à l'épaulement.

De préférence, le support comporte au moins un écran thermique interposé entre la face inférieure du porte-substrat et la table polarisée.

Suivant une caractéristique additionnelle, le support comporte une sonde de température au contact du porte-substrat.

A titre d'exemple, la sonde de température est raccordée à un organe de régulation qui alimente la résistance de chauffage.

Selon un mode de réalisation préférentiel, la table polarisée incorpore un réseau de refroidissement.

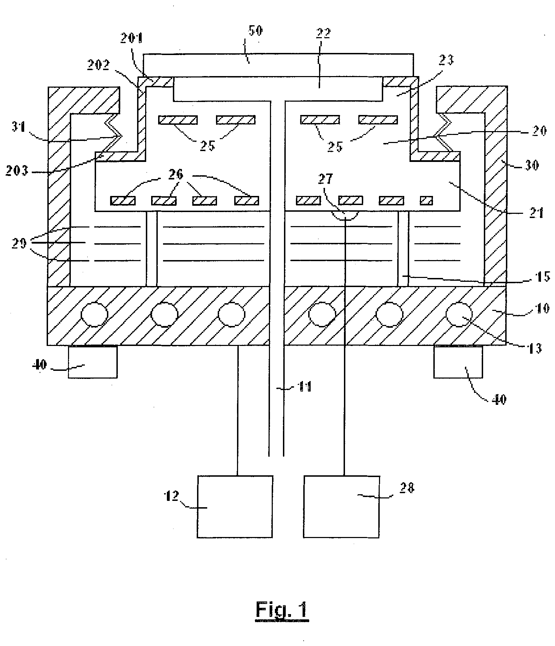

La présente invention apparaîtra maintenant avec plus de détails dans le cadre de la description qui suit d'un exemple de réalisation donné à titre illustratif en se référant à l'unique figure annexée qui représente schématiquement une coupe du support selon l'invention.

En référence à la figure, le support comprend essentiellement quatre parties :
- une table polarisée 10,
- un porte-substrat 20,
- une bride de serrage 30, et
- un socle 40.

Le socle 40 est l'organe solidaire de l'enceinte d'implantation sur lequel repose la table 10. Il est électriquement isolant.

La table 10 est traversée par un conduit 11 qui débouche d'une part dans le porte-substrat 20 et d'autre part à l'extérieur. La fonction de ce conduit 11 est détaillée plus loin.

La table 10 qui est électriquement conductrice se présente comme un plateau raccordé à une alimentation haute tension 12 qui fonctionne en mode continu ou en mode pulsé.

Suivant un mode de réalisation préférentiel, la table 10 est refroidie. A titre d'exemple, un réseau de refroidissement tubulaire 13 est noyé dans la table. Ce réseau est alimenté avec un quelconque fluide isolant électrique connu de l'homme de l'art. Il s'agit par exemple d'eau désionisée éventuellement additionnée de glycol ou bien d'huile.

périphérie de la table 10 par un quelconque moyen. D'autre part, elle presse sur l'épaulement 21 par l'intermédiaire de ressorts 31 qui sont eux aussi électriquement conducteurs et qui absorbent les dilatations différentielles.

La face supérieure du porte-substrat 20 présente un évidement 22, ce qui définit un anneau 23 à sa périphérie. L'épaisseur de l'anneau 23 vaut typiquement 10 à 15 µm. Le sommet de cet anneau définit un plan d'appui sur lequel repose le substrat 50.

Une série d'électrodes 25 est utilisée pour le serrage électrostatique du substrat. Les électrodes sont réparties par paires. Elles sont disposées dans un plan parallèle à la face supérieure du substrat 50, juste en dessous de l'évidement 22. Elles sont réalisées par tout moyen connu de l'homme du métier, par exemple en recourant à la technologie dite « couche épaisse ». Le principe consiste à réaliser un double condensateur :
- un condensateur anode-substrat,
- un condensateur substrat-cathode.

Revenant maintenant au conduit 11, celui-ci est employé pour emplir de gaz l'évidement 22. Le gaz caloporteur est couramment de l'hélium ou de l'hydrogène à une pression de 1 à 20 Torr. Sa fonction est de transmettre la chaleur du porte-substrat 20 à la face arrière du substrat 50.

Eventuellement, on peut prévoir un organe de vidange du gaz caloporteur. On pompe ce gaz à travers un circuit qui est rempli, lors de l'application de la haute tension, d'un autre gaz peu propice à générer un plasma, de l'azote par exemple, sous une pression supérieure à une atmosphère. On évite ainsi l'allumage d'un plasma de décharge dans ce circuit lors de l'application de la haute tension.

Il convient maintenant de revenir sur la chaîne qui assure la continuité électrique entre la table 10 et le substrat 50.

Un premier ruban métallique 201 est déposé sur l'anneau 23 qui figure à la périphérie de la face supérieure du porte-substrat 20. Il est réalisé par exemple suivant la technologie dite « couches minces » avec un matériau tel que titane, nitrure de titane, platine, tungstène, carbure de tungstène. Il faut en tout état de cause un matériau conducteur qui soit si possible réfractaire.

L'épaisseur du ruban doit être suffisante pour présenter une résistance électrique acceptable mais elle ne doit pas être trop élevée. Une valeur convenable pour cette épaisseur est comprise entre 1 µm et 3 µm.

Un deuxième ruban métallique 202 est déposé sur la paroi cylindrique du porte-substrat 20 entre le premier ruban 201 et l'épaulement 21.

Finalement, un troisième ruban métallique 203 est déposé sur la face de l'épaulement 21 qui vient en regard de la bride de serrage 30.

Les trois rubans ainsi juxtaposés assurent la continuité électrique depuis la face d'appui jusqu'à la bride de serrage qui est elle-même conductrice.

En effet, les ressorts 31 sont également électriquement conducteurs.

Le chauffage du porte-substrat 20 est réalisé au moyen d'une résistance chauffante 26. Cette résistance peut être collée. Elle peut aussi être intégrée dans le porte-substrat 20. Elle peut encore être déposée, en couche épaisse par exemple.

La température du porte-substrat 20 est contrôlée au moyen d'une sonde de température 27. Cette sonde peut être un thermocouple, une thermorésistance, une sonde platine ou un pyromètre. Elle est raccordée à un organe de régulation 28 qui alimente la résistance de chauffage 26. Cet organe de régulation 28 permet de maintenir une température stable quel que soit l'apport énergétique dû au plasma.

De préférence, on prévoit un ou plusieurs écrans 29 (trois sur la figure) qui sont interposés entre la base du porte-substrat 20 et la table polarisée 10. On limite ainsi les échanges thermiques entre ces deux éléments. Il s'agit d'écrans réflecteurs ou d'isolants thermiques.

Il apparaît que tous les équipements qui suivent sont portés à la tension de polarisation :
- convertisseur 28 de la sonde de température 27,
- alimentation de la résistance chauffante 26,
- alimentation des électrodes 25 du porte-susbtrat 20,
- régulateur de la pression du gaz caloporteur.

On prévoit donc un module de communication par fibre optique pour faire communiquer ces équipements avec l'automate de régulation.

On donne maintenant à titre indicatif un exemple d'un procédé d'implantation au moyen du support décrit ci-dessus :
- mise en température du porte-substrat 20,
- chargement du substrat 50 sur le porte-substrat 20,
- préchauffage du substrat durant 10 à 30 secondes,
- activation des électrodes 25 de serrage du substrat 50,
- injection du gaz caloporteur dans le conduit 11 sous une pression de 3 à 10 Torr,
- implantation ionique,
- arrêt de l'injection du gaz caloporteur et pompage de ce gaz,
- inactivation des électrodes 25 de serrage,
- déchargement du substrat 50.

Pour terminer, on précisera que la liaison électrique entre le substrat et la table polarisée peut être faite de bien des manières. On peut par exemple imaginer des trous métallisés pour assurer un contact entre le plan d'appui et la base ou face inférieure du porte-substrat. On peut aussi prévoir des inserts métalliques en lieu et place des trous métallisés. La continuité électrique est alors assurée par les pieds qui sont dans ce cas électriquement conducteurs.

Les exemples de réalisation de l'invention présentés ci-dessus ont été choisis eu égard à leurs caractères concrets. Il ne serait cependant pas possible de répertorier de manière exhaustive tous les modes de réalisation que recouvre cette invention. En particulier, tout moyen décrit peut être remplacé par un moyen équivalent sans sortir du cadre de la présente invention.

## Revendications

1. Support comportant :
- une table polarisée (10) électriquement conductrice raccordée à une alimentation haute tension (12) qui repose sur un socle (40) électriquement isolant,
- un porte-substrat (20) électriquement isolant prenant la forme d'un cylindre, sa face supérieure présentant un plan d'appui prévu pour recevoir un substrat (50), ledit porte-substrat (20) étant en outre pourvu d'un épaulement (21) à sa base,
- des pieds (15) qui reposent sur ladite table polarisée (10) pour supporter la face inférieure dudit porte-substrat (20),
- une bride de serrage (30) électriquement conductrice pour brider ledit épaulement (21) sur ladite table polarisée (10),
- au moins une liaison électriquement conductrice (201, 202, 203, 31, 30) pour raccorder ledit plan d'appui à ladite table polarisée (10), et le support comportant au moins un élément électriquement conducteur (201, 202, 203) pour raccorder ledit plan d'appui audit épaulement (21),
ledit élément électriquement conducteur comportant :
- un premier ruban (201) agencé à la périphérie de ladite face supérieure,
- un deuxième ruban (202) qui s'étend sur ledit cylindre entre ledit premier ruban (201) et ledit épaulement (21),
- un troisième ruban (203) au contact dudit deuxième ruban (202) agencé sur ledit épaulement (21),
le support étant **caractérisé en ce que** :
- celui-ci comprend des ressorts (31) électriquement conducteurs, ces ressorts étant agencés entre le troisième ruban (203) et ladite bride (30) et étant conçus pour absorber des dilatations différentielles ;
- ladite bride de serrage (30) est agencée pour presser sur l'épaulement (21) par l'intermédiaire desdits ressorts (31), et
- ledit porte-substrat (20) incorpore une résistance du chauffage (26).

2. Support selon l'une quelconque des revendications précédentes, **caractérisé en ce qu'**il comporte au moins un écran thermique (29) interposé entre la face inférieure dudit porte-substrat (20) et ladite table polarisée (10).

3. Support selon la revendication 1, **caractérisé en ce qu'**il comporte une sonde de température (27) au contact dudit porte-substrat (20).

4. Support selon la revendication 3, **caractérisé en ce que** ladite sonde de température (27) est raccordée à un organe de régulation (28) qui alimente ladite résistance de chauffage (26).

5. Support selon l'une quelconque des revendications précédentes, **caractérisé en ce que** ladite table polarisée (10) incorpore un réseau de refroidissement (13).

## Patentansprüche

1. Träger, umfassend:
- einen elektrisch leitenden polarisierten Tisch (10), der an eine Hochspannungsversorgung (12) angeschlossen ist, die auf einem elektrisch isolierenden Sockel (40) liegt,
- einen elektrisch isolierenden Substrathalter (20), der die Form eines Zylinders annimmt, wobei seine Oberseite eine Auflageebene aufweist, die dazu vorgesehen ist, ein Substrat (50) aufzunehmen, wobei der Substrathalter (20) außerdem an seiner Basis mit einer Schulter (21) versehen ist,
- Füße (15), die auf dem polarisierten Tisch (10) stehen, um die Unterseite des Substrathalters (20) zu tragen,
- einen elektrisch leitenden Klemmflansch (30), um die Schulter (21) an dem polarisierten Tisch (10) anzuflanschen,
- mindestens eine elektrisch leitende Verbindung (201, 202, 203, 31, 30), um die Auflageebene an den polarisierten Tisch (10) anzuschließen, und
wobei der Träger mindestens ein elektrisch leitendes Element (201, 202, 203) umfasst, um die Auflageebene an die Schulter (21) anzuschließen, wobei das elektrisch leitende Element Folgendes umfasst:
- einen ersten Streifen (201), der an der Peripherie der Oberseite angeordnet ist,
- einen zweiten Streifen (202), der sich auf dem Zylinder zwischen dem ersten Streifen (201) und der Schulter (21) erstreckt,
- einen dritten Streifen (203) in Kontakt mit dem zweiten Streifen (202), der auf der Schulter (21) angeordnet ist,
wobei der Träger **dadurch gekennzeichnet ist, dass**
- er elektrisch leitende Federn (31) umfasst, wobei diese Federn zwischen dem dritten Streifen (203) und dem Flansch (30) angeordnet sind und ausgelegt sind, um differentielle Dehnungen aufzunehmen;
- der Klemmflansch (30) angeordnet ist, um anhand der Federn (31) auf die Schulter (21) zu drücken, und
- der Substrathalter (20) einen Heizwiderstand (26) umfasst.

2. Träger nach einem der vorhergehenden Ansprüche, **dadurch gekennzeichnet, dass** er mindestens einen Wärmeschild (29) umfasst, der zwischen der Unterseite des Substrathalters (20) und dem polarisierten Tisch (10) eingeschoben ist.

3. Träger nach Anspruch 1, **dadurch gekennzeichnet, dass** er einen Temperaturfühler (27) in Kontakt mit dem Substrathalter (20) umfasst.

4. Träger nach Anspruch 3, **dadurch gekennzeichnet, dass** der Temperaturfühler (27) an ein Regelorgan (28) angeschlossen ist, das den Heizwiderstand (26) versorgt.

5. Träger nach einem der vorhergehenden Ansprüche, **dadurch gekennzeichnet, dass** der polarisierte Tisch (10) ein Kühlungsnetz (13) umfasst.

## Claims

1. A support comprising:
- an electrically conductive biased table (10) connected to a high voltage power supply (12) and supported on an electrically insulating stand (40),
- an electrically insulating substrate carrier (20) in the form of a cylinder, its top face presenting a bearing plane designed to receive a substrate (50), said substrate carrier (20) having further a shoulder 21 that projects from its base
- legs (15) standing on said biased table (10) in order to support the bottom face of said substrate carrier (20), and
- an electrically conductive clamping flange (30) for clamping said shoulder (21) against said biased table (10),
- at least one electrically conductive connection (201, 202, 203, 31, 30) for connecting said bearing plane to said biased table (10), and
the support including at least one electrically conductive element (201, 202, 203) for connecting said bearing plane to said shoulder (21), said electrically conductive element comprising:
- a first strip (201) arranged at the periphery of said top face;
- a second strip (202) that extends on said cylinder between said first strip (201) and said shoulder (21);
- a third strip (203) in contact with said second strip (202) and arranged on said shoulder (21),
said support being **characterized in that**:
- it comprises electrically conductive springs (31), these springs being arranged between the third strip (203) and said flange (30) and made to absorb differential expansion;
- said clamping flange (30) is arranged to press against the shoulder (21) via said springs (31), and
- said substrate carrier (20) incorporates a heating resistance (26).

2. A support according to any preceding claim, **characterized in that** it includes at least one thermal screen (29) interposed between the bottom face of said substrate carrier (20) and said biased table (10).

3. A support according to claim 1, **characterized in that** it includes a temperature probe (27) in contact with said substrate carrier (20).

4. A support according to claim 3, **characterized in that** said temperature probe (27) is connected to a regulator member (28) that powers said heating resistance (26).

5. A support according to any preceding claim, **characterized in that** said biased table (10) incorporates a cooling grid (13) .
